# EUROPEAN PATENT APPLICATION

(11) **EP 1 684 344 A2**
(43) Date of publication of application: **26.07.2006**
(21) Application number: 06250329.7
(22) Date of filing: 21.01.2006
(51) Int. Cl.: H01L 23/473

(54) **Heat sink**

(30) Priority: 25.01.2005 US 593553 P
(71) Applicant: Coolit Systems Inc., Calgary, Alberta T2A 7V8 (US)
(72) Inventor: Scott, Alexander Robin Walter, Calgery, Alberta T1Y 6B4 (CA)
(74) Representative: Chapman, Paul Nicholas

(57) **Abstract**

A heat sink includes: a first end; a second end; an exterior surface; a plurality of fins including a first fin and a second fin adjacent the first fin, each of the first fin and the second fin being substantially annular in form with an opening formed therethrough; a fin space between the first fin and the second fin to permit the flow of heat transfer fluid therethrough; a duct extending through the plurality of fins into which the fin space opens, the duct formed at least in part by corresponding arrangement of the openings of the first fin and the second fm, the duct opening at the first end of the heat sink to the exterior surface; and a thermal plate in heat conducting communication with the first fin and the second fin.

## Description

### Field of the Invention

The invention relates to the field of cooling electronic devices and, in particular, to heat sinks.

### Background

Heat sinks, also termed radiators or chillers, are used to conduct heat away from a heat source such as an electrical component directly or indirectly and into a passing fluid such as air. A heat sink generally may include a thermal plate and a number of fins protruding from the thermal plate. The thermal plate is installed in contact with the heat source such as on an electrical component or a thermal electrical conductor or in contact with a heat exchange liquid, often called a coolant. Where liquid coolant is used, for example, the liquid is pumped through a block on the heat source where it becomes heated and the heated liquid is then pumped or otherwise moves, as by movement through a heat pipe, to a heat sink located at some distance from the block. Once the heated liquid arrives at the heat sink, heat is conducted into the thermal plate and out into the fins where the heat is passed into a fluid such as an airflow passing through the fins. The airflow may be ambient or driven by a fan.

General information concerning heat sinks, is contained in applicant's corresponding published application WO 03/007372, dated January 23, 2003 and is incorporated herein by reference.

### Summary

In one aspect the invention provides a heat sink. The heat sink may include: a first end; a second end; an exterior surface; a plurality of fins including a first fin and a second fm adjacent the first fin, each of the first fin and the second fin being substantially annular in form with an opening formed therethrough; a fin space between the first fin and the second fin to permit the flow of heat transfer fluid therethrough; a duct extending through the plurality of fins into which the fin space opens, the duct formed at least in part by corresponding arrangement of the openings of the first fin and the second fin, the duct opening at the first end of the heat sink to the exterior surface; and a thermal plate in heat conducting communication with the first fin and the second fin.

It is to be understood that other aspects of the present invention will become readily apparent to those skilled in the art from the following detailed description, wherein various embodiments of the invention are shown and described by way of illustration. As will be realized, the invention is capable for other and different embodiments and its several details are capable of modification in various other respects, all without departing from the spirit and scope of the present invention. Accordingly the drawings and detailed description are to be regarded as illustrative in nature and not as restrictive.

### Drawings

Referring to the drawings wherein like reference numerals indicate similar parts throughout the several views, several aspects of the present invention are illustrated by way of example, and not by way of limitation, in detail in the figures, wherein:
Figure 1 is a front elevation of a heat sink according to the present invention;
Figure 2 is an end view of the heat sink of Figure 1;
Figure 3 is a front elevation of an assembled chiller including a heat sink and heat exchanger blocks installed thereon;
Figure 4 is an end view of another heat sink;
Figure 5 is an end view of another heat sink; and
Figure 6 is a sectional view along line 1-1 of Figure 5.

### Description of the Invention

In one aspect the invention provides a heat sink. The heat sink may include a first end, a second end, a duct extending along an axis into the heat sink, the duct opening at the first end of the heat sink and a plurality of fins arranged substantially annularly to define the duct with fin spaces between the fins opening into the duct.

In one embodiment, the duct may be open at just the first end of the heat sink or it may be open at both ends of the heat sink, thereby extending through the full length of the heat sink. The duct may be a substantially consistent shape along its length or may vary in shape or size.

The fins may surround the duct to define it. In one embodiment, a fin plate, which is the material defining a fin, has an opening therethrough and is formed substantially annular about the opening. With such a fin arrangement, the openings of the plurality of fins can be arranged to define the duct through the heat sink. The fin material can be substantially continuous about the opening. Of course, in an alternate embodiment the fins need not each be continuous about the opening defining the duct. For example, some or all of the fins may include a plurality of sections that together define a substantially annular form that can be arranged to define the duct.

The fin spaces, which are the open spaces necessary between fins to permit a heat exchange (i.e. cooling) fluid to flow therebetween, are open to the duct. In this way heat exchange fluid can be passed between the duct and the fin spaces. In one embodiment, for example, heat exchange fluid may pass from the duct out through the fin spaces. In another embodiment, a flow may be set up wherein the heat exchange fluid passes from the fin spaces to the duct. In one embodiment the fins may be configured to extend substantially orthogonally to the long axis defined by the length of the duct.

The heat sink may include a thermal plate configured to receive heat from one or more electronic devices for example by thermal coupling directly or indirectly therewith. The heat sink can, for example, if desired extract heat from an electronic device, such as a microprocessor, either directly or indirectly for example, via a liquid coolant or a thermal electric conductor (TEC).

A thermal plate can be positioned at an external side of the heat sink. For example, the thermal plate may be external to the duct and integral to or in thermal transfer communication with a plurality of fins. In one embodiment, the heat sink may include a plurality of thermal plates. The thermal plates may be spaced apart on the outer surface of the heat sink. In one embodiment, the thermal plates may be positioned at opposite sides of the heat sink with the fins extending therebetween so that the thermal plates and the heat-conducting components supported thereon do not completely block airflow through the fin spaces. In one embodiment, the heat sink may be formed to include at least two sides and each side may include a thermal plate with an open area therebetween to permit access between the thermal plates to the fin spaces.

The detailed description set forth below in connection with the appended drawings is intended as a description of various embodiments of the present invention and is not intended to represent the only embodiments contemplated by the inventor. The detailed description includes specific details for the purpose of providing a comprehensive understanding of the present invention. However, it will be apparent to those skilled in the art that the present invention may be practiced without these specific details.

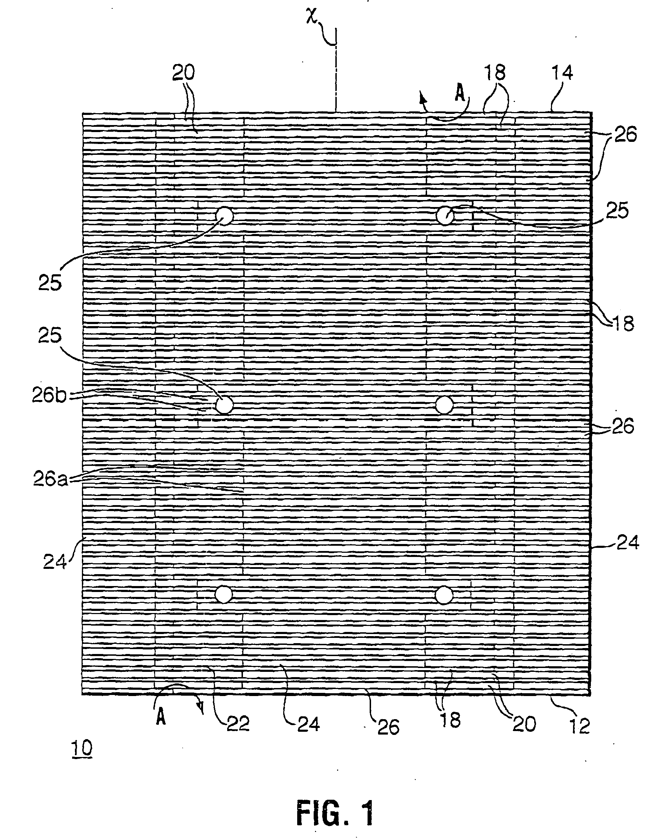

Referring to Figures 1 to 3, a heat sink 10 is shown including a first end 12, a second end 14, a duct 16 extending to open at both the first end and the second end. The length of the duct defines an axis x. A plurality of fins 18 are arranged annularly about the axis to define the duct. Each of the fins are spaced apart to define fin spaces 20 between adjacent fins. The fins are arranged such that the fin spaces open into the duct. In one embodiment, the fins may each define a plane and the planes of at least some and possibly all of the fins may intersect the axis x of duct 16 so that the fin spaces open to the duct. In the illustrated embodiment, the planes of fins 18 extend substantially orthogonal to axis x.

The illustrated heat sink further defines four external side surfaces 22 each having a thermal plate 24 formed thereon. The fins each extend in heat conducting communication with at least one thermal plate. While the heat sink may include only one thermal plate, the arrangement of a plurality of thermal plates, such as that shown or other arrangements, permits a single heat sink to be operated with heat input from a number of its sides. The fins and thermal plates are formed of heat conducting material such that heat energy applied to the surfaces of the thermal plates can spread through the thermal plates and be conducted through the fins. Heat energy may then be dissipated from the fins into a heat conducting fluid passing between the fins through the fin spaces and between the thermal plates, for example along arrows A. The thermal plate shapes may be varied as desired. For example in the illustrated embodiment, the material of the thermal plates is extended at some positions along its length to provide an anchor point, herein illustrated with fastener holes 25, for accepting a mounting device.

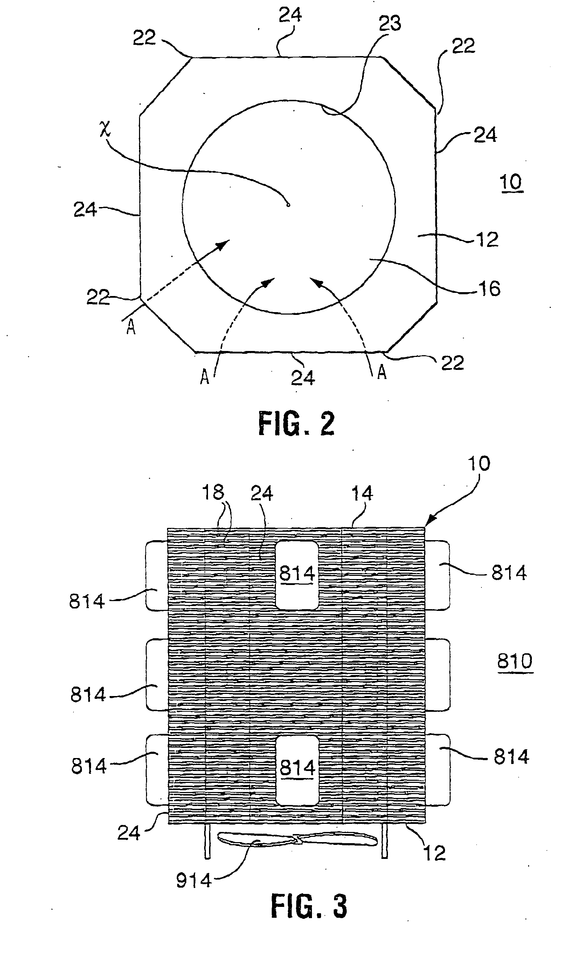

Of course, the dimensions of the heat sink and its components may vary significantly depending on size requirements, materials, fluid viscosity of the air flow, etc. However, as an example of one possible embodiment, the fins may be 0.5 to 1.5mm thick and spaced a distance of 1.0 to 2.5mm. The fins may be formed substantially planar and positioned with their planes substantially in parallel to enhance laminar flow therethrough. The planes of the fins may extend substantially perpendicularly to the thermal plates and may extend substantially perpendicularly to the axis of the duct. The fins may be formed of plate-like materials with an opening, as indicated by reference numeral 23 in Figure 2, formed therethrough such that the openings of the various fins may be arranged, when the fins are positioned in side by side relation, to form the duct. Where a fin includes an opening, the material of that fin may be annular about the opening and possibly substantially continuous about the opening, if desired. The opening on a fin may be substantially equidistant from the side perimeter edges of the fin such that the opening is positioned generally centrally on the fin.

The duct may be sized to accommodate a fan at its open end or ends or to accommodate a fan, such as a squirrel cage fan, therein. The fan can be oriented to force air into the duct and out to the fins or in an opposite orientation to draw air through the fins to the duct, as is shown by arrows A.

The heat sink can be formed in any desired way that meets the requirements of heat conduction. In one embodiment, the fins may be assembled and the thermal plates secured or mounted on the heat sink to be in heat conducting communication with the fins on which it is mounted. In another embodiment, the fins may be formed as part of the thermal plates. Such a heat sink is described in applicant's earlier application known as EP 04 254 771.1, filed August 11, 2004. In such an embodiment, the fins are integral with the thermal plates. One or more edges of each fin may form a part of one or more thermal plates. In one embodiment, an edge portion of each fin forms a portion of the external surface of each thermal plate. In one embodiment, the fins may extend continuously between at least two thermal plates to which they are formed integral. Where a fin is continuous and formed as a part of a plurality of thermal plates, the fin may more efficiently handle heat input and may offer a better use of fin surface area and a more stable temperature over the entire surface of a fin to enhance fin material, and thereby heat sink, performance. It may-be desirable, in some instances to form the fins such that the thermal plates are positioned substantially similar distances from the duct to have uniform heat distribution about the fin.

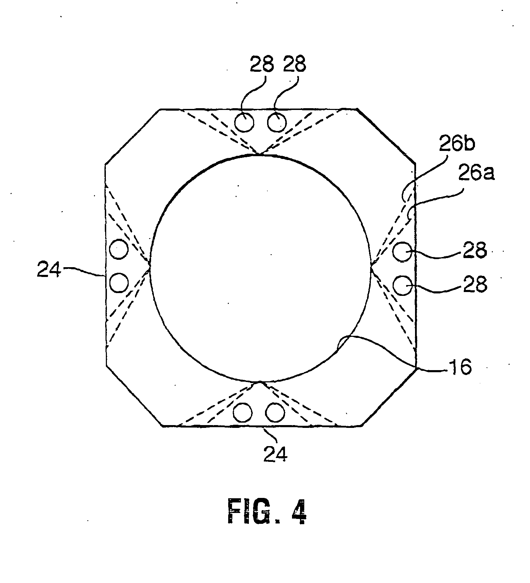

In one method of assembly, where the thermal plates are formed integral with edges of the fins and spacers, the fins may be formed as annular plates and may be mounted in alternating fashion with spacers 26. The plates and spacers may then be held together and secured in place, as by brazing. With such a heat sink construction, assembly may be facilitated by use of correspondingly spaced apertures 28 (Figure 4) formed through the fin plates and spacers, through which the plates and spacers can be alternately positioned over assembly spikes before being connected together. The fin plates and spacers are each formed of heat conducting material and, for example, may include anodized aluminum, aluminum, copper, alloys, etc.

Where spacers are used to form the thermal plates, the spacers may be used to vary the dimensions of the thermal plate. For example in the illustrated embodiments of Figures 1 and 4, two sizes of spacers 26a, 26b are used, with spacers 26b extending out past spacers 26a, such extended length forming the material into which fastener holes 25 are drilled.

Figure 3 illustrates a chiller 810 for an electronic device such as a personal computer (PC). The chiller is assembled and includes a heat sink 10 and chiller heat exchangers 814. Some possible forms of heat exchangers are described in WO03/007372. The chiller may operate to pass heat from the heat sink to air passing thereby. As such, the chiller can operate in cooperation with a fan 914. Although one fan is shown, more than one fan may be used for various reasons such as, for example, to reduce sympathetic vibrations. Also, although fan 914 is shown mounted at an end of the duct, a fan can be used that is positioned within the duct, if desired.

The heat sink of Figure 3 is in this illustration similar to that of Figure 1, but it is to be understood that the heat sink can be varied in a number of ways. For example the length, shape and/or configuration of the duct, the construction, size, number and orientation of the plurality of fins, the form, number and arrangement of thermal plates, etc. can all be altered.

Chiller 810 may be mountable in alignment with an opening in a wall of the case of a PC. When installed in the case of the PC, heat exchangers 814 become heat sources for the heat sink. The chiller heat exchangers 814 may, for example, be blocks through which a heated fluid may be circulated and/or may include TECs.

In operation, chiller 810 may accept heat energy from a fluid that has picked up heat from a component, such as a microprocessor, within the computer, which fluid is pumped through the chiller heat exchangers 814. The thermal plates 24 in turn receive the heat energy from the heat exchangers or other means such as thermoelectric pumps and transfer that heat to the fins 18. Air, forced or drawn between the fins by fan 914 picks up heat from the fins and carries that heat out of the case of the PC.

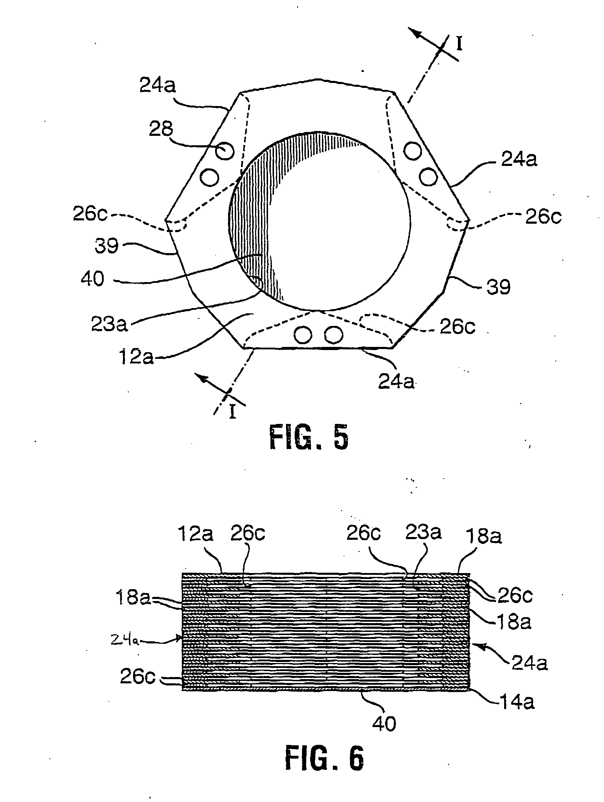

With reference to Figures 5 and 6, another heat sink is shown. The embodiment of Figures 5 and 6 includes a plurality of fins 18a in which a space 20a is formed between each adjacent pair of fins by a plurality of spacers 26c. The shape and positions of spacers 26c are shown in phantom in Figure 5. The fins and spacers 26c are connected together, as by brazing, along three exterior side surfaces to form three thermal plates 24a. A heat sink with three thermal plates may provide a smaller footprint to permit it to be positioned in smaller spaces, but as stated previously, numbers of thermal plates and size are of course not intended to be limited herein.

Fins 18a each also include an opening 23a formed therethrough and positioned generally centrally between the fin edges forming the three thermal plates. Since greater fin material can provide greater surface area for heat transfer to cooling fluid passing between the fins, the fin surface area is increased in this embodiment by providing convex edges 39 between thermal plates 24a.

Fins 18a are arranged in the heat sink so that the openings together form a duct. The heat sink includes an end cap 40 that closes the duct at end 14a, while the duct remains open at end 12a.

The fins each include a plurality of positioning apertures 28a used during assembly and manufacture of the heat sink.

The previous description of the disclosed embodiments is provided to enable any person skilled in the art to make or use the present invention. Various modifications to those embodiments will be readily apparent to those skilled in the art, and the generic principles defined herein may be applied to other embodiments without departing from the spirit or scope of the invention. Thus, the present invention is not intended to be limited to the embodiments shown herein, but is to be accorded the full scope consistent with the claims, wherein reference to an element in the singular, such as by use of the article "a" or "an" is not intended to mean "one and only one" unless specifically so stated, but rather "one or more". All structural and functional equivalents to the elements of the various embodiments described throughout the disclosure that are know or later come to be known to those of ordinary skill in the an are intended to be encompassed by the elements of the claims. Moreover, nothing disclosed herein is intended to be dedicated to the public regardless of whether such disclosure is explicitly recited in the claims. No claim element is to be construed under the provisions of 35 USC 112, sixth paragraph, unless the element is expressly recited using the phrase "means for" or "step for".

## Claims

1. A heat sink comprising: a first end; a second end; an exterior surface; a plurality of fins including a first fin and a second fin adjacent the first fin, each of the first fin and the second fin being substantially annular in form with an opening formed therethrough; a fin space between the first fin and the second fin to permit the flow of heat transfer fluid therethrough; a duct extending through the plurality of fins into which the fin space opens, the duct formed at least in part by corresponding arrangement of the openings of the first fin and the second fin, the duct opening at the first end of the heat sink to the exterior surface; and a thermal plate in heat conducting communication with the first fin and the second fin.

2. The heat sink of claim 1 wherein the first fin and the second fin each include side surfaces formed substantially planar and are positioned with their side surfaces substantially parallel.

3. The heat sink of claim 1 wherein the duct includes an axis along which it extends and the first fin and the second fin each include side surfaces formed substantially planar and defining a plane therethrough and the first fin and the second fin are positioned with their planes intersecting the axis of the duct.

4. The heat sink of claim 1 wherein the duct opens to the exterior surface also at the second end of the heat sink.

5. The heat sink of claim 1 wherein the first fin is formed as a plate including perimeter edges and wherein the opening of the first fin is positioned substantially centrally between the perimeter edges.

6. The heat sink of claim 1 wherein the heat sink first comprises spacers positioned between the first fin and the second fin to maintain the fin space therebetween.

7. The heat sink of claim 1 wherein the first fin is formed integral with the thermal plate.

8. The heat sink of claim 1 wherein the thermal plate is one of a plurality of thermal plates.

9. The heat sink of claim 8 wherein the plurality of thermal plates are positioned on the exterior surface of the heat sink and the duct is positioned substantially centrally between the plurality of thermal plates.

10. The heat sink of claim 1 wherein the plurality of fins include perimeter edges and the thermal plate is formed by brazing along a portion of the perimeter edges of the plurality of fins.

11. The heat sink of claim 1 wherein the plurality of fins include apertures for use in positioning over an assembly spike during manufacture.

12. The heat sink of any of claims 1 to 11 in a chiller assembly including a fan within the duct.

13. The heat sink of any of claims 1 to 11 in a chiller assembly including a fan positioned at an open end of the duct.

14. The heat sink of any of claims 1 to 13 in a chiller assembly including a heat source mounted on the thermal plate.

15. The heat sink of claim 1 wherein the plurality of fins include positioning apertures for use in positioning the plurality of pins over an assembly spike during manufacture.
